# EUROPEAN PATENT SPECIFICATION

(11) **EP 3 163 130 B1**
(45) Date of publication and mention of the grant of the patent: **28.08.2019**
(21) Application number: 15814263.8
(22) Date of filing: 30.06.2015
(51) Int. Cl.: F16J 9/26, F02F 5/00, C23C 28/04, C23C 14/06, C23C 30/00, C23C 14/14, C23C 14/02, C23C 14/16

(54) **PISTON RING**
KOLBENRING
SEGMENT DE PISTON

(30) Priority: 30.06.2014 JP 2014134957
(43) Date of publication of application: 03.05.2017
(73) Proprietor: Nippon Piston Ring Co., Ltd., Saitama-shi, Saitama 338-8503 (JP)
(72) Inventor: CHIDA, Noriaki, Saitama-shi Saitama 338-8503 (JP); OKANO, Masataka, Saitama-shi Saitama 338-8503 (JP)
(74) Representative: Grünecker Patent- und Rechtsanwälte PartG mbB
(86) International application number: PCT/JP2015/068896
(87) International publication number: WO 2016/002810

(56) References cited:
- DE-A1-102008 017 583
- JP-A- 2000 001 767
- JP-A- 2006 265 646
- JP-A- 2008 286 354

## Description

### Field of the Invention

The present invention relates to a piston ring having excellent wear resistance, cracking resistance, and peeling resistance.

### BACKGROUND ART

A piston ring used in an internal combustion engine is used under a harsh environment of high temperature and high pressure, requiring further improvement in wear resistance and the like. For example, an outer peripheral sliding surface of the piston ring slides and comes into contact with an inner peripheral surface of a cylinder liner, and thus requires particularly superior wear resistance. Thus, a chrome plated film, a nitride layer, a hard film formed by a physical vapor deposition (PVD) method, or the like is used. Then, in response to the above-described demand, a chrome plated film, a nitriding treated film, or a hard film of chromium nitride (CrN, Cr₂N), titanium nitride (TiN), or the like fabricated by a PVD method is formed on the outer peripheral sliding surface and top and bottom surfaces of the piston ring.

However, in association with the reduced weight and increased output of internal combustion engines in recent years, the piston ring is used under even harsher environments. In particular, a piston ring used in an internal combustion engine of an alcohol fuel vehicle capable of running on an alcohol fuel, or a flexible-fuel vehicle (FFV) or a dual-fuel vehicle capable of running on two or more types of fuels such as gasoline, methanol, and ethanol is susceptible to wear resistant film cracking and peeling, resulting in a desire for even higher wear resistance. The cracking and peeling of the wear resistant film is caused by a chemical reaction that occurs between the great amount of moisture produced from the alcohol included in the fuel and the wear resistant film formed on the outer peripheral sliding surface of the piston ring.

In response to such demands, Patent Document 1, for example, proposes a sliding member covered with a hard film having improved sliding characteristics and, in particular, peeling resistance. In this technique, the outer peripheral surface of the piston ring is covered with a hard film by arc ion plating, and the hard film is made of a CrN-based chromium nitride, and has a crystal lattice constant within a range of 0.4145-0.4200 nm and a Cr content of 30-49 at.%.

Further, Patent Document 2 proposes a sliding member covered with a film having excellent wear resistance, scuffing resistance, and characteristics that do not cause an increase in the wear of an opposing material (aggressiveness against mated). In this technique, the outer peripheral surface of the sliding member is covered with a Cr-V-B-N alloy film, and the Cr-V-B-N alloy film is formed by a physical vapor deposition method, in particular an ion plating method, a vacuum deposition method, or a sputtering method, and has a V content of 0.1-30 mass% and a B content of 0.05-20 mass%.

Further, Patent Document 3 proposes a sliding member on which a Cr-B-Ti-N alloy film having excellent wear resistance and scuffing resistance is formed. In this technique, the piston ring comprises a base material, a nitride layer, and a Cr-B-Ti-N alloy film, and the Cr-B-Ti-N alloy film is made to cover the outer peripheral sliding surface (sliding surface equivalent area) of the nitride layer by a PVD (physical vapor deposition) method, includes B in an amount of 0.05-10.0 mass%, Ti in an amount of 5.0-40.0 mass% and N in an amount of 10.0-30.0 mass%, and has a remnant of Cr. Document DE 19927997 discloses a coating alloy for a piston ring with improved wear resistance made of an alloy of Cr-B-V-N.

### Patent Documents

Patent Document 1: Japanese Laid-Open Patent Application No. 2001-335878
Patent Document 2: Japanese Laid-Open Patent Application No. 2000-1767
Patent Document 3: Japanese Laid-Open Patent Application No. 2006-265646

### SUMMARY OF THE INVENTION

### Problems to be Solved by the Invention

Nevertheless, in each of the above-described patent documents, the high wear resistance demanded in recent years has not been adequately satisfied. Furthermore, for example, an internal combustion engine that uses an alcohol fuel or an alcohol-containing fuel is susceptible to wear resistant film cracking and peeling as a result of a chemical reaction that occurs between the great amount of moisture produced from the alcohol contained in the fuel and the wear resistant film formed on the outer peripheral sliding surface of the piston ring.

The present invention was made to resolve the above-described problems, and it is therefore an object of the present invention to provide a piston ring having higher wear resistance, cracking resistance, and peeling resistance.

### Means for Solving the Problems

A piston ring according to the present invention for resolving the above-described problems is a piston ring comprising a sliding surface covered with a Cr-B-V-Ti-N alloy film, wherein a B content is within a range of 0.1-1.5 mass% inclusive, a V content is within a range of 0.05-1 mass% inclusive, and a ratio [B content / V content] is within a range greater than 1 and 30 or less, wherein the Ti content is within a range of 1.9-8 mass%, the Cr content is within a range of 55-61 mass% inclusive, and the N content is within a range of 32-40 mass% inclusive.

The piston ring may be configured so as to be mounted on an engine that uses an alcohol fuel or an alcohol-containing fuel.

The piston ring may be configured so that the alloy film is more porous on a base material side than a front surface side of the piston ring.

The piston ring according to the present invention may be configured so that a nitriding treated layer or a metal underlayer is provided as an underlayer of the alloy film.

### Effect of the Invention

According to the present invention, it is possible to provide a piston ring according to claim 1, wherein a B content is within a range of 0.1-1.5 mass% inclusive, a V content is within a range of 0.05-1 mass% inclusive, and a ratio [B content / V content] is within a range greater than 1 and 30 or less, thereby achieving a piston ring comprising a wear resistant film having higher wear resistance, cracking resistance, and peeling resistance. Such a piston ring may be preferably applied to an internal combustion engine that uses an alcohol fuel or an alcohol-containing fuel, for example, and achieves the effect of making it possible to suppress the occurrence of cracking and peeling to a greater degree than a conventional wear resistant film.

### BRIEF DESCRIPTION OF THE DRAWINGS

Figs. 1A and 1B are schematic cross-sectional views illustrating an example of a piston ring according to the present invention.
Fig. 2 is a graph showing the relationship between a ratio [B content / V content] and a wear rate.
Fig. 3 is an explanatory view of an Amsler wear test method.
Fig. 4 is an explanatory view of a wear test method that uses an alcohol-containing fuel.
Figs. 5A to 5C are images showing evaluation criteria for test results obtained by the wear test method illustrated in Fig. 4.

### Embodiments of the Invention

The following describes in detail the piston ring according to the present invention. The present invention is not limited to the following embodiments alone, and encompasses other embodiments that fall under the scope of the appended claims.

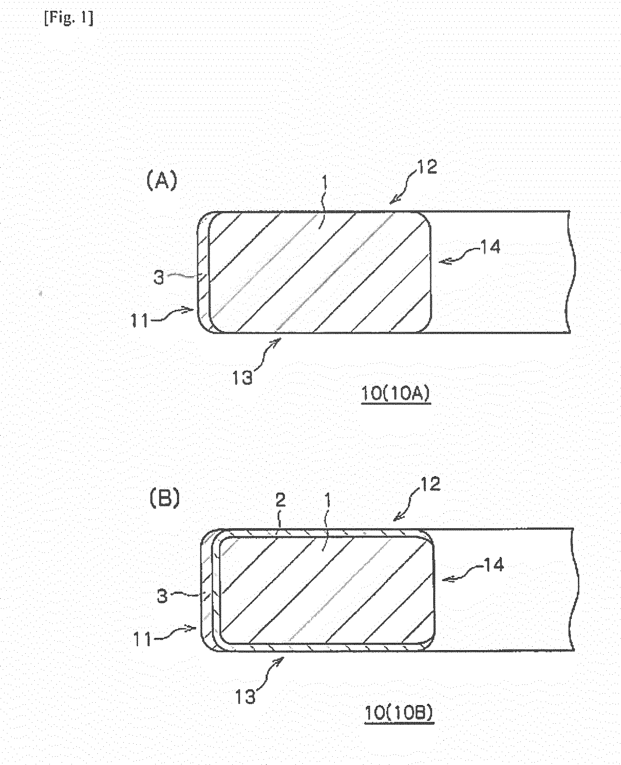

A piston ring 10 (10A, 10B) according to the present invention, as illustrated in Figs. 1A and 1B, is a piston ring comprising a sliding surface 11 covered with a Cr-B-V-Ti-N alloy film. In the alloy film 3, a B content is within a range of 0.1-1.5 mass% inclusive, a V
content is within a range of 0.05-1 mass% inclusive, and a ratio [B content / V content] is within a range greater than I and 30 or less.

According to this piston ring 10, the alloy film 3 has high wear resistance, cracking resistance, and peeling resistance, may be preferably applied to an internal combustion engine that uses an alcohol fuel or an alcohol-containing fuel, for example, and achieves the effect of making it possible to suppress the occurrence of cracking and peeling to a greater degree than a conventional wear resistant film.

The following describes in detail the components of the piston ring according to the present invention.

### (Base material)

Examples of the materials used as a base material 1 of the piston ring 10 are various and not particularly limited. For example, materials such as various steel materials, stainless steel materials, casting materials, cast steel materials, and the like can be applied. Among these, preferable examples include a martensitic stainless steel, a chromium manganese steel (SUP9) which is a spring steel, a chrome-vanadium steel (SUP10), a silicon chrome steel (SWOSC-V), and the like.

The base material 1 may be pretreated as necessary. Examples of the pretreatment include processing that polishes the front surface to adjust the surface roughness. This adjustment of the surface roughness is performed by, for example, methods such as lapping and polishing the front surface of the base material 1 using diamond abrasive grains.

### (Underlayer)

An underlayer 2 of the alloy film 3 is provided as necessary to the base material 1, as illustrated in Fig. 1B. Examples of the underlayer 2 include a nitriding treated layer, a metal underlayer, and the like. While such an underlayer 2 is preferably formed on at least the outer peripheral sliding surface 11 on which sliding occurs upon contact by the piston ring 10 with a cylinder liner (not illustrated), the underlayer 2 may be formed on other surfaces, such as a top surface 12 and a bottom surface 13 and, as necessary, further on an inner peripheral surface 14 of the piston ring 10.

When a stainless steel is applied as the base material 1, for example, the nitriding treated layer is a hard nitride layer formed as an underlayer by diffusing and carburizing nitrogen on the front surface of the stainless steel. The nitriding treated layer is preferably used as the underlayer of the piston ring. It should be noted that the nitride treatment may be performed using conventionally known methods. While a thickness of the nitriding treated layer is not particularly limited, a thickness within a range 10-50 µm inclusive is preferred.

Examples of the metal underlayer include a metal layer of titanium or chromium. The metal underlayer made of titanium or chromium may be formed by various film-forming means. Examples of applicable film-forming means include a vacuum deposition method, a sputtering method, and an ion plating method. While a thickness of the metal underlayer is not particularly limited, a thickness within a range 0.1-2 µm inclusive is preferred.

### (Alloy film)

The alloy film 3 is provided on the base material 1, or on the underlayer 2 when the underlayer 2 is provided on the base material 1. This alloy film 3 is preferably provided at least on the outer peripheral sliding surface 11 of the piston ring 10. The outer peripheral sliding surface 11 of the piston ring 10 comes into contact with the cylinder liner serving as an opposing material when the piston slides, and thus provision of the alloy film 3 to at least the outer peripheral sliding surface 11 makes it possible to achieve a piston ring with excellent wear resistance, cracking resistance, and peeling resistance. The alloy film 3 may be formed on the top surface 12 and the bottom surface 13 serving as surfaces other than the outer peripheral sliding surface 11 and, as necessary, further formed on the inner peripheral surface 14.

Examples of the alloy film 3 include a Cr-B-V-N alloy film. Examples of the Cr-B-V-N alloy film include a quaternary Cr-B-V-N alloy film, which does not form part of the invention but is disclosed for a better understanding, and quinary Cr-B-V-Ti-N alloy film.

The quaternary Cr-B-V-N alloy film 3, which does not form part of the invention, is configured so that the B content is within a range of 0.1-1.5 mass% inclusive, the V content is within a range of 0.05-1 mass% inclusive, and the ratio [B content / V content] is within a range greater than 1 and 30 or less. B solidifies in Cr-N, and is effective in increasing the fineness of crystals. Then, an alloy film that includes B increases toughness and improves wear resistance. V forms a fine nitride, and is effective in improving toughness and heat resistance. An alloy film that includes V can increase durability in an environment having poor lubrication.

The quinary Cr-B-V-Ti-N alloy film 3 is an alloy film in which the above-described quaternary Cr-B-V-N alloy film further includes Ti, and is similarly configured so that the B content is within a range of 0.1-1.5 mass% inclusive, the V content is within a range of 0.05-1 mass% inclusive, the ratio [B content / V content] is within a range greater than 1 and 30 or less, and further the Ti content is within a range of 1.9-8 mass%. Ti forms a fine nitride and acts so as to strengthen the underlying material. Furthermore, an alloy film that includes Ti may exhibit effectiveness when applied to a piston ring used in an engine that uses an alcohol fuel or an alcohol-containing fuel, for example. Possible reasons for this include that, with an ethanol fuel, for example, the alcohol and Ti or TiN chemically react, causing elution from the front surface of the alloy film 3, and a reaction with moisture to form TiO₂. This TiO₂ then reacts with the alcohol to produce a metal alkoxide, condense, and form a polyoxy-titanium gel on the front surface of the alloy film 3, thereby protecting the front surface.

In the quaternary or quinary alloy film 3 described above, as understood from the examples described later, the B content and the V content are within the above-described ranges, and the ratio [B content / V content] is within the above-described range, making it possible to exhibit excellent wear resistance. With a B content less than 0.1 mass%, the B
content is too small and thus the V content must be significantly decreased to satisfy the ratio [B content / V content], possibly resulting in failure to exhibit adequate wear resistance. When the B content exceeds 1.5 mass%, wear resistance decreases. Further, with a V content less than 0.05 mass%, the V content is too small and the inclusion of V does not produce the effect of improving wear resistance. When the V content exceeds 1 mass%, the residual stress of the film increases, making the film susceptible to fine cracks, and resulting in deterioration in wear resistance. Further, from a cost perspective, an increased V content increases costs, making processing difficult in terms of the manufacture of the target (evaporation source) as well.

When the ratio [B content / V content] is 1 or less, the wear resistance cannot be regarded as adequate. Further, when the ratio [B content / V content] exceeds 30, the B content is significantly large compared to the V content, resulting in a brittle and porous film tissue and thus a reduction in wear resistance. Further, processing is difficult in terms of the manufacture of the target (evaporation source) as well.

It should be noted that a more preferred range of the B content is within a range of 0.6-1.2 mass% inclusive. A more preferred range of the V content is within a range of 0.1-0.5 mass% inclusive. A more preferred range of the ratio [B content / V content] is within a range of 1.2-12 inclusive. The quaternary or quinary alloy film 3 comprising these preferred ranges can exhibit higher wear resistance.

In the alloy film 3 of the piston ring according to the present invention, the Ti content is within a range of 1.9-8 mass%. By the inclusion of Ti within this range, Ti contributes to strengthening the underlying material of the film in an alloy film and, with an alcohol fuel or an alcohol-containing fuel, forms polyoxy-titanium on the front surface due to chemical changes, thereby making it possible to further increase wear resistance. A more preferred range of the Ti content is within a range of 1.9-7.1 mass% inclusive, which makes it possible to even further increase wear resistance.

It should be noted that, in the alloy film 3 that does not include Ti and does not form part of the invention, preferably the Cr content is within a range of 60-64 mass% inclusive, and the N content is within a range of 31-39 mass% inclusive. Further, in the alloy film 3 that includes Ti, the Cr content is within a range of 55-61 mass% inclusive, and the N content is within a range of 32-40 mass% inclusive.

The alloy film 3 is normally formed on at least the outer peripheral sliding surface 11 of the piston ring 10 by a PVD (physical vapor deposition) method. Examples of the PVD method include an ion plating method, a vacuum deposition method, a sputtering method, and the like. While a thickness of the formed alloy film 3 is not particularly limited, a thickness within a range 3-20 µm inclusive is preferred.

The alloy film 3 thus formed is preferably more porous on the base material side than the front surface side (sliding surface side) of the piston ring. Making the base material side more porous than the front surface side results in the alloy film on the base material side
having a porous intermediate layer. This intermediate layer is advantageous in that it acts so as to alleviate the stress between the alloy film 3 on the front surface side and the base material or underlayer, making it possible to improve an adhesive force. The composition of the porous intermediate layer on the base material side is the same as the composition of the dense alloy film 3 on the front surface side, and can be formed by adjusting film formation conditions. Such an intermediate layer may have a uniform composition in a thickness direction, or a composition that changes in the thickness direction, and the thickness, while not particularly limited, is within a range of 0.01-20 µm inclusive, for example, and preferably around 5 µm (3-8 µm inclusive).

It should be noted that the porous intermediate layer on the base material side and the dense alloy film 3 on the front surface side can be easily analyzed by image analysis using a cross-section polisher (CP). These make it possible to change and control a bias voltage and a nitrogen gas pressure, for example. While not particularly limited, each of these can be formed by maintaining the nitrogen gas pressure inside the chamber at 50 mTorr and setting the bias voltage to -7 V when forming the porous intermediate layer, and setting the nitrogen gas pressure to 25 mTorr and the bias voltage to -7 V when forming the dense alloy film 3, for example. Further, the porous intermediate layer can be formed by setting the nitrogen gas pressure inside the chamber to 25 mTorr and the bias voltage to 0 V. Further, the dense alloy film 3 can be formed by setting the nitrogen gas pressure inside the chamber to 9 mTorr and the bias voltage to -10 V.

The hardness of the alloy film 3 (the dense alloy film 3 on the front surface side) is preferably within a range of 1600-2000 inclusive by Vickers hardness (JIS B 7725, ISO 6507) Hv (0.05). Vickers hardness can be measured using a micro Vickers hardness tester (manufactured by Future-Tech) or the like, and "HV (0.05)" indicates the Vickers hardness at a load of 50 gf.

### (Other)

Another film may be provided on the alloy film 3 as necessary. Examples of such a film include a diamond-like carbon.

### (Applied fuel)

The piston ring 10 according to the present invention exhibits high wear resistance, making it possible to preferably mount the piston ring 10 not only on an engine that uses a regular gasoline fuel, but also on an engine that uses an alcohol fuel or an alcohol-containing fuel. While the cylinder internal pressure inside the engine increases with a flex fuel vehicle that uses an alcohol fuel or an alcohol-containing fuel, making the piston ring having a conventional wear resistant film formed thereon susceptible to the occurrence of wear resistant film cracking and peeling, the piston ring 10 according to the present invention may be preferably applied to an internal combustion engine that uses an alcohol fuel or an alcohol-containing fuel, for example, and achieves the effect of making it possible to suppress the occurrence of cracking and peeling to a greater degree than a conventional wear resistant film.

The following describes the piston ring according to the present invention in further detail.

### [Examples 1-3 and Comparative Examples 1-3]

A piston ring base material equivalent to a SUS440B material (17Cr stainless steel) as defined in JIS standards, including C: 0.85 mass%, Si: 0.4 mass%, Mn: 0.3 mass%, Cr: 17.5 mass%, Mo: 1.1 mass%, V: 0.1 mass%, P: 0.02 mass%, S: 0.02 mass%, and a remnant of iron and unavoidable impurities, was used as the base material 1. The base material 1 was ultrasonically cleaned in an organic solvent in advance.

Next, the Cr-B-V-N alloy film 3 was formed on the base material 1. The film was formed by generating an arc discharge on the front surface using an arc ion plating device and a Cr-B-V alloy having the same composition ratios as the composition ratios expected after film formation as the target. Further, nitrogen gas and, as necessary, a predetermined amount of inert gas (here, an argon gas) were introduced into the chamber that performed arc discharge, and a bias voltage of 5-30 V was applied to form the 20-µm Cr-B-V-N alloy films 3 of examples I to 3 and comparative examples 1 to 3, as shown in Table 1. The examples 1 - 3 in table 1 are not part of the invention.

The obtained alloy films 3 comprised a porous intermediate layer on the base material side and a dense alloy film 3 on the front surface side, and the film was formed by maintaining the nitrogen gas pressure inside the chamber at 25 mTorr and setting the bias voltage to 0 V when forming the porous intermediate layer on the base material side, and setting the nitrogen gas pressure to 25 mTorr and the bias voltage to -16V when forming the dense alloy film 3 on the front surface side. It should be noted that the B content and the V content of the obtained alloy films 3 are shown in Table 1, and the Cr content and the N content were Cr content: 62.08 mass% and N content: 36.51 mass% in example 1, Cr content: 62.93 mass% and N content: 36.25 mass% in example 2, Cr content: 62:53 mass% and N content: 35.98 mass% in example 3, Cr content: 58.63 mass% and N content: 33.45 mass% in comparative example 1, Cr content: 62.61 mass% and N content: 36.24 mass% in comparative example 2, and Cr content: 61.37 mass% and N content: 36.12 mass% in comparative example 3.

### [Conventional Example 1]

In the conventional example 1, a Cr-B-N tertiary alloy film was formed in place of the alloy films formed in each of the examples 1 to 3 and the comparative examples 1 to 3 described above. All other aspects were the same as those of the examples 1 to 3 and the comparative examples 1 to 3. The wear rates are indicated in Tables 1 and 2, given 1 as the wear rate of this conventional example I. A value less than 1 indicates a higher wear resistance than that of the conventional example 1. It should be noted that the film formation conditions in this case include a nitrogen gas pressure of 25 mTorr and a bias voltage of -16V, resulting in a dense film along the entire thickness direction. In this conventional example 1, the Cr content was 61.29 mass% and the N content was 37.20 mass%.

### [Table 1]

**Table 1**

| | Content (mass%) | | B/V Content Ratio | Wear Rate |
|---|---|---|---|---|
| | B | V | | |
| Example 1 | 1.30 | 0.12 | 10.8 | 0.17 |
| Example 2 | 0.43 | 0.39 | 1.1 | 0.18 |
| Example 3 | 1.44 | 0.06 | 24.0 | 0.51 |
| Comparative Example 1 | 1.07 | 6.85 | 0.2 | 1.93 |
| Comparative Example 2 | 0.40 | 0.75 | 0.5 | 1.14 |
| Comparative Example 3 | 2.44 | 0.07 | 34.9 | 1.81 |
| Conventional Example 1 | 2.0 | - | - | 1 |

### [Examples 4-8 and Comparative Examples 4-7]

In the examples 4 to 8 and the comparative examples 4 to 7, a Cr-B-V-Ti-N quinary alloy film was formed using a target that included Ti in the examples 1 to 3 and the comparative examples 1-3 described above. All other aspects were the same as those of the examples 1 to 3 and the comparative examples 1 to 3. It should be noted that, in example 8 only, the nitrogen gas pressure was set to 25 mTorr and the bias voltage was set to -16V, resulting in a dense alloy film 3 along the entire thickness direction. It should also be noted that the B content, the V content, and the Ti content of the obtained alloy films 3 are shown in Table 2, and the Cr content and the N content were Cr content: 57.94 mass% and N content: 33.14 mass% in example 4, Cr content: 59.14 mass% and N content 34.70 mass% in example 5, Cr content: 59.55 mass% and N content: 35.85 mass% in example 6, Cr content: 59.99 mass% and N content: 36.58 mass% in example 7, Cr content: 59.74 mass% and N content: 35.72 mass% in example 8, Cr content: 56.39 mass% and N content: 31.27 mass% in comparative example 4, Cr content: 58.94 mass% and N content: 35.75 mass% in comparative example 5, Cr content: 51.28 mass% and N content: 26.75 mass% in comparative example 6, and Cr content: 56.89 mass% and N content: 31.70 mass% in comparative example 7.

### [Table 2]

**Table 2**

| | Content (mass%) | | | B/V Content Ratio | Wear Rate |
|---|---|---|---|---|---|
| | B | V | Ti | | |
| Example 4 | 1.19 | 0.70 | 7.04 | 1.7 | 0.46 |
| Example 5 | 1.03 | 0.25 | 4.88 | 4.1 | 0.63 |
| Example 6 | 1.05 | 0.51 | 3.04 | 2.1 | 0.44 |
| Example 7 | 0.97 | 0.48 | 1.99 | 2.0 | 0.52 |
| Example 8 | 0.99 | 0.53 | 3.02 | 1.9 | 0.41 |
| Comparative Example 4 | 1.38 | 0.68 | 10.29 | 2.0 | 1.90 |
| Comparative Example 5 | 0.86 | 0.92 | 3.54 | 0.9 | 1.20 |
| Comparative Example 6 | 2.25 | 14.2 | 5.53 | 0.2 | 1.54 |
| Comparative Example 7 | 1.11 | 0.32 | 9.98 | 3.5 | 2.12 |
| Conventional Example 1 | 2.0 | - | - | - | 1 |

### [Wear Test]

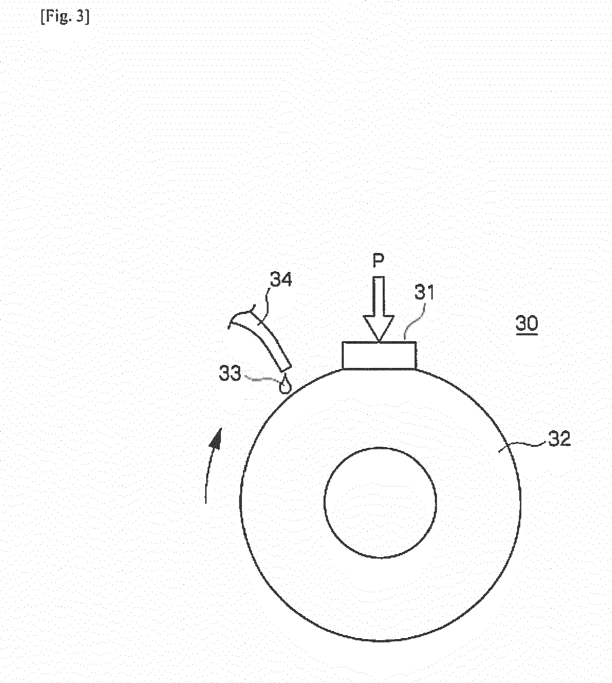

The wear rates indicated in Tables 1 and 2 were measured by using an Amsler wear tester 30 illustrated in Fig. 3, measurement samples 31 (length: 7 mm, width: 8 mm, height: 5 mm) obtained under the same conditions as those of the piston rings obtained in the conventional example 1, the examples 1 to 8, and the comparative examples 1 to 7 described above as stationary pieces, and a doughnut-shaped (outer diameter 40 mm, inner diameter 16 mm, thickness: 10 mm) object as an opposing material 32 (rotating piece), causing the measurement sample 31 and the opposing material 32 to come into contact, and then applying a load P. A friction coefficient test was conducted using each of the measurement samples 31 under test conditions including a lubricant 33: machine oil (kinematic viscosity: 1.01 at 100°C, and 2.2 at 40°C), oil temperature: room temperature, rotating speed: 100 rpm, load: 400 N, test period: 21 hours, and boron cast iron as the opposing material 32. The oil drip rate from a drip tube 34 was 0.04 mL/min. It should be noted that the opposing material 32 made from boron cast iron was first ground into a predetermined shape and then sequentially surface-ground after changing the fineness of the grinding stone, making adjustments so as to achieve a final roughness of 1-2 µm Rz (10-point average roughness, compliant with JIS B0601 (1994)).

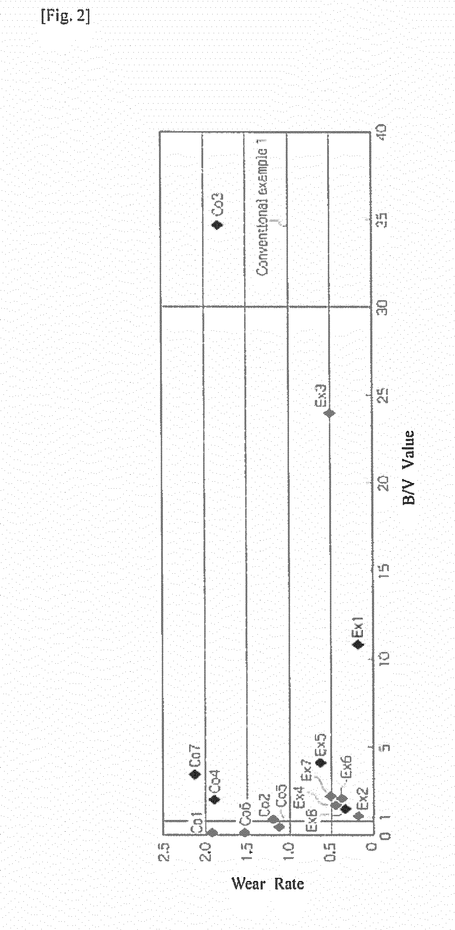

The test results are shown in Fig. 2 and Tables 1 and 2 as wear rates. The wear rates are each expressed as a rate given I as the amount of wear in the conventional example 1. In Fig. 2, "Ex1" to "Ex8" are abbreviations for examples 1 to 8, "Co1" to "Co7" are abbreviations for comparative examples 1 to 7, and "Conventional example 1" indicates conventional example 1. The alloy films within the composition ranges according to the present invention all exhibited a wear rate of less than 1 and a high wear resistance. Based on these results, the B, V, and Ti contents illustrated in examples 4 to 8 in Table 2 2 were clearly found to exhibit a favorable wear resistance compared to the conventional example I and the comparative examples 1 to 7 at least within the above-described ranges.

### [Wear Test Using Ethanol-Containing Fuel]

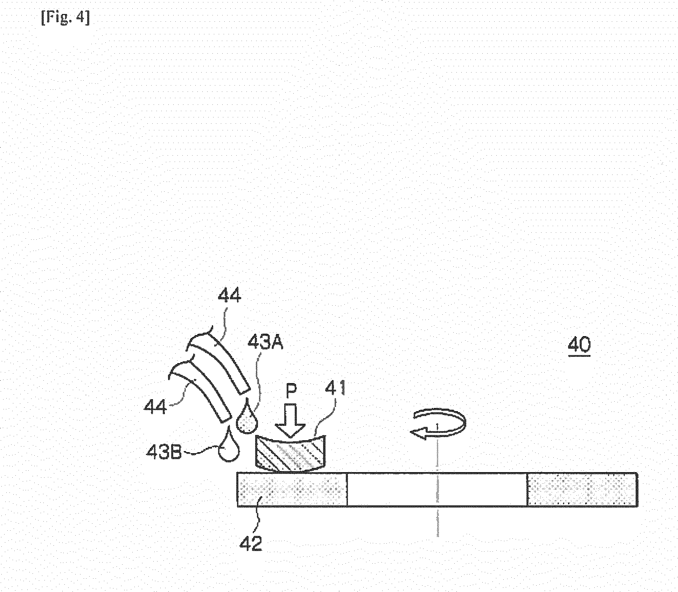

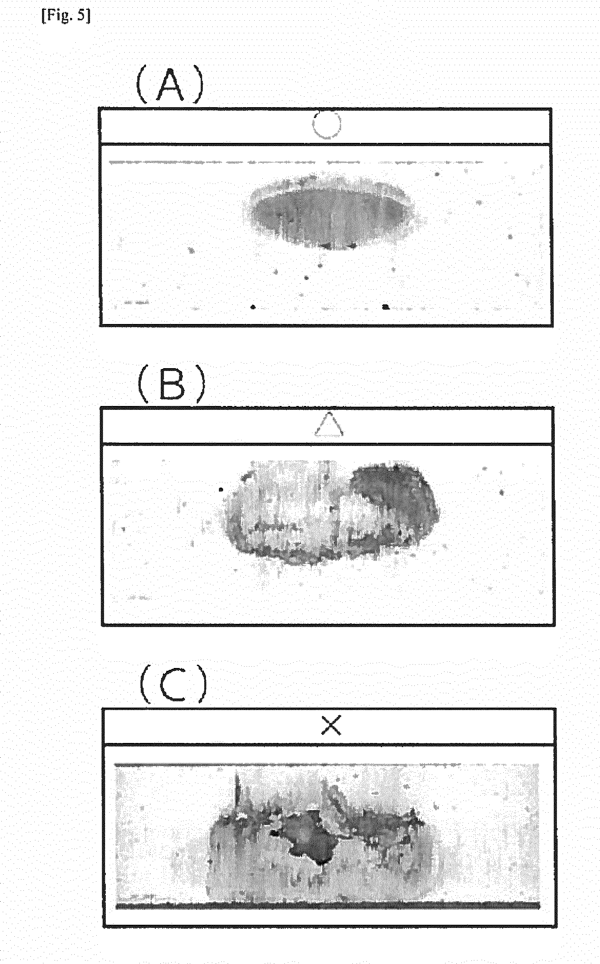

Fig. 4 is an explanatory view of a wear test method that uses an alcohol-containing fuel, and Figs. 5A to 5C are images showing evaluation criteria for the test results obtained using the wear test method. The wear test was conducted using a tester 40 that performs the wear test method illustrated in Fig. 4 by simultaneously dripping an ethanol 43A with 30% water added thereto and an engine oil 43B from drip tubes 44 and 44, respectively, setting the rotation speed of an opposing material 42 to 1500 rpm, and using FC 250 as the opposing material 42. The outer peripheral sliding surface 11 of the piston ring 10 having the alloy film 3 formed thereon was established as a measurement sample 41, and the predetermined load P was applied. The temperatures of the dripping ethanol 43A and the engine oil 43B were about the same as room temperature. The test pattern involved one cycle of establishing the target load in 2 seconds, maintaining the target load for 5 seconds, releasing the load in I second, and maintaining the released state for 1 second, and then repeating this cycle 1000 times. The results are shown in Table 3. Figs. 5A to 5C are images showing the evaluation criteria for the test results. A O mark indicates that cracking and peeling were not seen, a Δ mark indicates that cracking and peeling were not seen but adhesion was severe, and an X mark indicates that cracking and peeling were seen.

### [Table 3]

**Table 3**

| | Load (kgf) | | |
|---|---|---|---|
| | 7.5 | 10 | 15 |
| Conventional Example 1 | × | - | - |
| Comparative Example 6 | ○ | × | - |
| Example 2 | ○ | ○ | × |
| Example 4 | ○ | ○ | ○ |
| Example 5 | ○ | ○ | ○ |
| Example 6 | ○ | ○ | ○ |
| Example 7 | ○ | ○ | ○ |
| Example 8 | ○ | ○ | Δ |

As understood from the results in Table 3, in examples 2 and 4 to 8, no cracking or peeling was seen when the load P was 7.5 kgf and 10 kgf. When the load P was an extremely high 15 kgf, peeling was somewhat apparent in example 2, but the alloy films of examples 4 to 7, which included Ti, exhibited favorable surface characteristics without cracking or peeling. It should be noted that, when the load P was an extremely high 15 kgf, the alloy film of example 8 did not exhibit cracking or peeling, but severe adhesion occurred. The reason for this is presumably that a porous intermediate layer was not provided, causing characteristics to be somewhat inadequate compared to examples 4 to 7.

### Descriptions of Reference Numerals

- 1: Base material
- 2: Underlayer
- 3: Alloy film
- 10, 10A, 10B: Piston ring
- 11: Sliding surface (Outer peripheral sliding surface)
- 12: Top surface
- 13: Bottom surface
- 14: Inner peripheral surface
- 30: Wear tester
- 31: Measurement sample
- 32: Opposing material
- 33: Lubricant
- 34: Drip tube
- 40: Wear tester
- 41: Measurement sample
- 42: Opposing material
- 43A: Ethanol with 30% water added
- 43B: Engine oil
- 44: Drip tube
- P: Load

## Claims

1. A piston ring comprising a sliding surface covered with a Cr-B-V-Ti-N alloy film;
a B content being within a range of 0.1-1.5 mass% inclusive, a V content being within a range of 0.05-1 mass% inclusive, and a ratio [B content / V content] being within a range greater than 1 and 30 or less, wherein
the Ti content is within a range of 1.9-8 mass%, the Cr content is within a range of 55-61 mass% inclusive, and the N content is within a range of 32-40 mass% inclusive.

2. The piston ring according to claim 1, wherein
a nitriding treated layer or a metal underlayer is provided as an underlayer of the alloy film.

## Patentansprüche

1. Kolbenring, der eine Gleitfläche umfasst, die mit einem Cr-B-V-Ti-N-Legierungs-Film überzogen ist;
wobei ein B-Gehalt in einem Bereich von einschließlich 0,1 bis einschließlich 1,5 Massen-% liegt, ein V-Gehalt in einem Bereich von einschließlich 0,05 bis einschließlich 1 Massen-% liegt, und ein Verhältnis [B-Gehalt/V-Gehalt] in einem Bereich von über 1 bis 30 oder weniger liegt, und
der Ti-Gehalt in einem Bereich von 1,9 bis 8 Massen-% liegt, der Cr-Gehalt in einem Bereich von einschließlich 55 bis einschließlich 61 Massen-% liegt und der N-Gehalt in einem Bereich von einschließlich 32 bis einschließlich 40 Massen-% liegt.

2. Kolbenring (1) nach Anspruch 1, wobei
eine Nitrier-Behandlung unterzogene Schicht oder eine Unterschicht aus Metall als eine Unterschicht des Legierungs-Films vorhanden ist.

## Revendications

1. Segment de piston comprenant une surface de glissement recouverte d'un film d'alliage Cr-B-V-Ti-N;
une teneur en B comprise entre 0,1 et 1,5% en masse, une teneur en V comprise entre 0,05 et 1% en masse et un rapport [teneur en B/teneur en V] compris entre 1 et 30 ou moins, dans lequel
la teneur en Ti est comprise entre 1,9 et 8% en masse, la teneur en Cr est comprise entre 55 et 61%, inclus, en masse et la teneur en N est comprise entre 32 et 40%, inclus, en masse.

2. Segment de piston selon la revendication 1, dans lequel
une couche traitée par nitruration ou une sous-couche métallique est fournie en tant que sous-couche du film d'alliage.
